# EUROPÄISCHE PATENTANMELDUNG

(11) **EP 1 318 545 A1**
(43) Veröffentlichungstag der Anmeldung: **11.06.2003**
(21) Anmeldenummer: 01811189.8
(22) Anmeldetag: 06.12.2001
(51) Int. Cl.: H01L 23/48, H01L 25/07

(54) **Leistungshalbleiter-Submodul und Leistungshalbleiter-Modul**

(71) Anmelder: ABB RESEARCH LTD., 8050 Zürich (CH)
(72) Erfinder: Zwick, Fabian, 8134 Adliswil (CH); Bijlenga, Bo, 662 33 Amal (SE); Erne, Patrick, 8352 Elsau (CH); Hamidi, Amina, 5400 Baden (CH); Kaufmann, Stefan, 5000 Aarau (CH); Meysenc, Luc, 5405 Baden-Dättwil (CH)
(74) Vertreter: ABB Patent Attorneys

(57) **Zusammenfassung**

Das Leistungshalbleiter-Submodul (1) umfasst zwischen zwei Hauptanschlüssen (6, 7) wenigstens zwei Halbleiterchips (21, 22), welche zwei Hauptelektroden (3, 4) umfassen, wobei auf die eine Hauptelektrode (3) durch ein Kontaktstempel (8) eine Kontaktkraft ausgeübt wird und der Halbleiterchip (21, 22) so mit der anderen Hauptelektrode (4) auf eine Grundplatte (5) gedrückt wird. Die beiden Halbleiterchips (21, 22) zwischen den beiden Hauptanschlüssen (6, 7) des Leistungshalbleiter-Submoduls sind elektrisch in Serie geschaltet.

Dadurch, dass die beiden Halbleiterchips wie bei herkömmlichen Press Pack Modulen nebeneinander auf der Grundplatte angeordnet sind, erhöht sich die Bauhöhe des erfindungsgemässen Leistungshalbleiter-Submoduls nicht. Hingegen wird durch die elektrische Serienschaltung die maximale Sperrspannung des Leistungshalbleiter-Submoduls erhöht.

## Beschreibung

### Technisches Gebiet

Die Erfindung bezieht sich auf das Gebiet der Leistungselektronik. Sie betrifft ein Leistungshalbleiter-Submodul nach dem Oberbegriff des Patentanspruchs 1 sowie ein Leistungshalbleiter-Modul.

### Stand der Technik

Im Hochleistungsbereich werden Leistungshalbleiter-Module in der Druckkontakttechnik (Press Pack Module) gefertigt. Diese Press Pack Module werden als Hochleistungsschalter im Hochspannungsbereich bis 1'000 kV für Ströme bis zu mehreren kA eingesetzt. Da ein Insulated Gate Bipolar Transistor (IGBT), wie er heute in einem Press Pack Modul verwendet wird, lediglich eine Spannung von rund einigen kV sperren kann, werden für einen Hochspannungsschalter mehrere Press Pack Module in mindestens einem Stapel (Stack) in Serie geschaltet. Der Stack mit bis mehreren Dutzend Press Pack Modulen wird mit einer Kraft von rund 100 kN zusammengepresst.
Ein Press Pack Modul, wie es etwa in EP 762'496 beschrieben ist, umfasst in der Regel mehrere, nebeneinander angeordnete Halbleiterchips, welche mit ihrer ersten Hauptelektrode auf einer Grundplatte aufgebracht sind. Die zweiten Hauptelektroden der Halbleiterchips werden von einer Mehrzahl von Kontaktstempeln kontaktiert. Die Grundplatte ist mit einem ersten Hauptanschluss und die Kontaktstempel sind mit einem zweiten Hauptanschluss verbunden. Die Hauptanschlüsse können scheibenförmig ausgebildet sein und mittels Flanschen zusammengehalten werden. Der Druckkontakt ist also in Form eines Kupferstempels ausgebildet, welcher auf die einzelnen Chips drückt.
Die einzelnen Halbleiterchips des Press Pack Moduls werden heute vielfach gruppiert und in vorfabrizierbaren Einheiten (Submodul) zusammengefasst. Dabei sind die Halbleiterchips zueinander parallel geschaltet, beispielsweise mehrere IGBT- und Dioden-Chips gemeinsam in einem Submodul.
Ein Stack mit Press Pack Modulen erreicht eine Länge von mehreren Metern. Um den oben erwähnten Druck über eine solche Länge ausüben zu können, sind aufwendige Vorkehrungen notwendig. Es ist daher erstrebenswert, die maximale Sperrspannung pro Längeneinheit in einem Stack zu erhöhen, um für eine gegebene Spannung mit weniger Press Pack Modulen auszukommen.
Durch eine Erhöhung der Sperrspannung einzelner Press Pack Module könnten die Höhe des Stacks und die damit verbundenen Kosten reduziert werden. Leider ist die oben erwähnte maximale Sperrspannung der Leistungshalbleiterchips mit der heutigen Technologie kaum zu überbieten.

### Kurze Darstellung der Erfindung

Es ist daher die Aufgabe der vorliegenden Erfindung, ein Leistungshalbleiter-Submodul und ein Leistungshalbleiter-Modul der eingangs genannten Art zu schaffen, welche bei im wesentlichen gleichbleibender Bauhöhe eine höhere Sperrspannung aufweisen.
Diese Aufgabe wird erfindungsgemäss mit einem Leistungshalbleiter-Submodul mit den Merkmalen des Patentanspruchs 1 sowie einem Leistungshalbleiter-Modul mit den Merkmalen des Patentanspruchs 9 gelöst.
Das erfindungsgemässe Leistungshalbleiter-Submodul umfasst zwischen zwei Hauptanschlüssen wenigstens zwei Halbleiterchips, welche zwei Hauptelektroden umfassen, wobei auf die eine Hauptelektrode durch einen Kontaktstempel eine Kontaktkraft ausgeübt wird und der Halbleiterchip so mit der anderen Hauptelektrode auf eine Grundplatte gedrückt wird. Die beiden Halbleiterchips zwischen den beiden Hauptanschlüssen des Leistungshalbleiter-Submoduls sind elektrisch in Serie geschaltet.
Dadurch, dass die beiden Halbleiterchips wie bei herkömmlichen Press Pack Modulen nebeneinander auf der Grundplatte angeordnet sind, erhöht sich die Bauhöhe des erfindungsgemässen Leistungshalbleiter-Submoduls nicht. Hingegen wird durch die elektrische Serienschaltung die maximale Sperrspannung des Leistungshalbleiter-Submoduls erhöht.

In einer ersten Ausführungsform sind Isolationsschichten zwischen dem einen Halbleiterchip und der Grundplatte sowie zwischen dem anderen Halbleiterchip und dem entsprechenden Kontaktstempel angeordnet. Die beiden Halbleiterchips sind an den dadurch isolierten Elektroden mit einer Verbindungsleitung elektrisch leitend verbunden.
Auf diese Weise ergibt sich eine einfache Serienschaltung, wobei der Strom vom einen Hauptanschluss über einen ersten Kontatkstempel und den einen Halbleiterchip durch die Verbindungsleitung und den anderen Halbleiterchip zur Grundplatte und dem damit verbundenen anderen Hauptanschluss fliesst.
In einer ersten vorteilhaften Variante der ersten Ausführungsform umfasst die Verbindungsleitung zwei elektrisch leitfähige Platten, welche über eine dazwischenliegende Verbindungsschicht elektrisch verbunden sind.
Die beiden Platten sind im wesentlichen flach ausgebildet. Der Höhenunterschied zwischen den beiden Platten, bedingt durch die auf verschiedenen Ebenen liegenden Hauptelektroden der beiden Halbleiterchips, wird durch die elektrisch leitende Verbindungsschicht überbrückt.
In einer zweiten vorteilhaften Variante der ersten Ausführungsform ist die Grundplatte im Bereich des von der Grundplatte isolierten Halbleiterchips dicker ausgebildet, so dass die über die Verbindungsleitung verbundenen Hauptelektroden der beiden Halbleiterchips im wesentlichen in einer Ebene liegen.
Dadurch kann die Verbindungsleitung wiederum im wesentlichen flach ausgebildet werden.
In einer zweiten Ausführungsform ist die eine Isolationsschicht zwischen dem einen Halbleiterchip und der Grundplatte verlängert bis zum anderen Halbleiterchip, welcher dadurch ebenfalls von der Grundplatte isoliert ist. Zusätzlich ist dieser Halbleiterchip im Vergleich zur ersten Ausführungsform umgekehrt angeordnet (flip-chip), so dass die auf der Isolationsschicht angeordnete Verbindungsleitung die in der Serienschaltung verbundenen Elektroden der beiden Halbleiterchips verbindet. Von der zweiten, mit einer Isolationsschicht von dem entsprechenden Kontaktstempel isolierten Elektrode des umgekehrt angeordneten Halbleiterchips führt eine weitere Verbindungsleitung zur Grundplatte.

Als Verbindungsleitungen können beispielsweise Kupfer-Bondverbindungen verwendet werden. Diese sind leicht zu montieren und günstig erhältlich. Weiter können, insbesondere für grosse Ströme von mehr als 1 kA, Metalldrahtgeflechte, Metalldrähte oder Metallfolien eingesetzt werden.
In einer dritten Ausführungsform ist wiederum zwischen der einen Hauptelektrode des einen Halbleiterchips und der Grundplatte eine elektrisch isolierende Schicht angeordnet ist. Zudem ist zwischen dem einen Hauptanschluss und dem die eine Hauptelektrode des anderen Halbleiterchips kontaktierenden Kontaktstempel eine zweite elektrisch isolierende Schicht angeordnet. Die eine isolierte Elektrode des einen Halbleiters ist mit dem isolierten Kontaktstempel des anderen Halbleiters wiederum über eine Verbindungsleitung verbunden.
In einer vorteilhaften Variante der dritten Ausführungsform umfasst die Verbindungsleitung zwei elektrisch leitfähige Platten, welche zwischen der Hauptelektrode und der Isolationsschicht, beziehungsweise dem Kontaktstempel und der Isolationsschicht angeordnet sind, und einem zusätzlichen, die beiden Platten elektrisch leitend verbindenden Kontaktstempel.
Die Verbindungsleitung ist nur aus robusten Metallteilen gefertigt. Die Serienschaltung wird mit einfachen, geraden Metall- und Isolationsteilen ermöglicht. Dadurch ergeben sich Vorteile bei der Montage.
Im erfindungsgemässen Leistungshalbleiter-Submodul und/ oder im erfindungsgemässen Leistungshalbleiter-Modul lassen sich einfache Schaltungen realisieren, beispielsweise eine Parallelschaltung eines IGBTs mit zwei seriengeschalteten Dioden.
Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert. Es zeigen:
- Fig. 1: ein Schnitt durch ein erfindungsgemässes Leistungshalbleiter-Submodul nach einer ersten Ausführungsform,
- Fig. 2: eine erste vorteilhafte Variante des Leistungshalbleiter-Submoduls nach Fig. 1,
- Fig. 3: eine zweite vorteilhafte Variante des Leistungshalbleiter-Submoduls nach Fig. 1,
- Fig. 4: ein Schnitt durch ein erfindungsgemässes Leistungshalbleiter-Submodul nach einer zweiten Ausführungsform,
- Fig. 5: ein Schnitt durch ein erste Variante des erfindungsgemässen Leistungshalbleiter-Submodul nach einer dritten Ausführungsform,
- Fig. 6: ein Schnitt durch ein zweite Variante des erfindungsgemässen Leistungshalbleiter-Submodul nach einer dritten Ausführungsform, und
- Fig. 7: ein Schnitt durch ein erfindungsgemässes Leistungshalbleiter-Modul.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Weg zur Ausführung der Erfindung

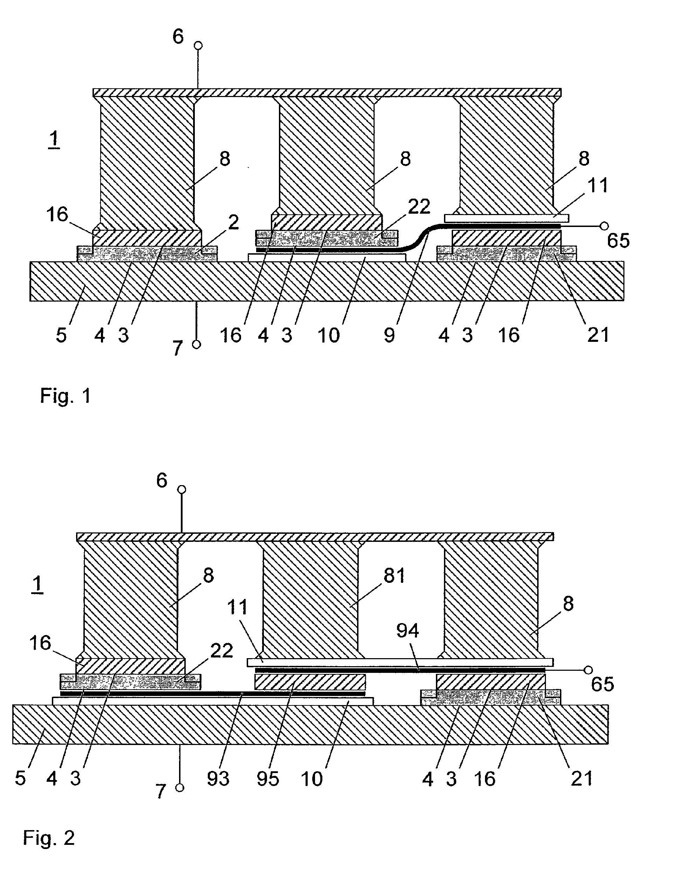

Fig. 1 zeigt eine erste Ausführungsform des erfindungsgemässen Leistungshalbleiter-Submoduls. Mit 1 ist das Leistungshalbleiter-Submodul bezeichnet, welches einen ersten und einen zweiten Hauptanschluss 7 und 6 aufweist. Die Hauptanschlüsse 6, 7 sind in den Zeichnungen nur symbolisch dargestellt, der zweit Hauptanschluss ist wenigstens in Form einer leitfähigen Platte angedeutet. Sie können beispielsweise aus einem massiven Kupferblock bestehen. Eine Grundplatte 5 ist mit dem ersten Hauptanschluss 7 verbunden. Die Grundplatte kann beispielsweise eine Molybdänplatte oder ein Platte aus anderen geeigneten Materialien sein, welche mit einer Lotschicht auf dem ersten Hauptanschluss befestigt ist. Der Grundriss der Grundplatte kann rund oder eckig sein.
Auf die Grundplatte 5 sind mehrere, allgemeiner mindestens zwei Halbleiterchips aufgelötet. Vorzugsweise handelt es sich bei den Halbleiterchips um IGBT-Chips oder um Diodenchips oder um eine Kombination dieser Arten von Chips. Grundsätzlich weisen die Chips jedoch mindestens zwei Hauptelektroden 3 und 4 auf, welche beispielsweise von den entsprechenden Hauptanschlüssen 6 und 7 kontaktiert werden. Im Falle von IGBT-Chips ist noch eine dritte Elektrode, eine Steuerelektrode vorgesehen, welche über einen nicht dargestellten Anschlussdraht mit einem Steueranschluss verbunden ist. Der Anschlussdraht wird dabei beispielsweise auf die Steuerelektrode des entsprechenden Chips gebondet. Die Halbleiterchips sind Teil eines Stapels aus mehreren Schichten, beispielsweise Lötschichten oder Schichten zur Verbesserung des Kurzschlussverhaltens (short circuit failure mode, SCFM), wie in EP 989 611 ausführlich beschrieben. In den Figuren ist symbolisch jeweils lediglich der Halbleiterchip sowie eine unmittelbar darüber angeordnete SCFM-Schicht 16 gezeigt.
Im dargestellten Beispiel umfasst das Leistungshalbleiter-Modul 1 drei Halbleiterchips, einen IGBT 2 sowei dazu parallel geschaltet, zwei seriengeschaltete Dioden 21 und 22.
Die eine, erste Hauptelektrode 4 wird durch die Unterseite der Chips 2, 21 und 22 gebildet. Die andere, zweite Hauptelektrode 3, wird entsprechend durch die Oberseite der Chips gebildet.
Der IGBT 2 liegt mit der ersten Hauptelektrode 4 auf der Grundplatte 5 auf und ist über sie mit dem ersten Hauptanschluss 7 elektrisch leitend verbunden. Die zweite Hauptelektrode 3 des IGBT 2 ist über einen Kontaktstempel 8 mit dem zweiten Hauptanschluss 6 elektrisch leitend verbunden.
Die genaue Ausführung und Wirkung der Kontatkstempel 8 ist für die Erfindung nicht ausschlaggebend. Es ist davon auszugehen, dass die Lage der Kontaktstempel entsprechend einem Abstand von den Halbleiterchips zu einem die Kontaktstempel aufnehmenden Hauptanschluss individuell einstellbar ist. Die Kontaktstempel können dabei beispielsweise entweder mittels einem Federelement mit Druck beaufschlagt oder mittels einer Lotschicht fixiert werden.
Die erste der beiden Dioden 21 liegt ebenfalls mit der ersten Hauptelektrode 4 auf der Grundplatte 5 auf. Die zweite Diode 22 liegt ebenfalls mit der ersten Hauptelektrode 4 auf der Grundplatte 5, allerdings ist sie durch eine erste elektrisch isolierende Schicht 10 von der Grundplatte elektrisch isoliert. Während die zweite Hauptelektrode 3 dieser zweiten Diode 22 über den Kontaktstempel 8 mit dem Hauptanschluss 6 elektrisch leitend verbunden ist, ist zwischen der zweiten Hauptelektrode 3 der ersten Diode 21 und dem darüberliegenden Kontaktstempel 8 eine zweite elektrisch isolierende Schicht 11 angeordnet. Die beiden elektrisch isolierten Hauptelektroden sind nun über eine Verbindungsleitung 9 elektrisch leitend miteinander verbunden. Auf diese Weise ergibt sich eine Serienschaltung der beiden Dioden 21 und 22 zwischen den beiden Hauptanschlüssen 7 und 6. Ein Anschluss 65 an die Verbindungsleitung kann zur externen Kontaktierung ebenso wie der Steueranschluss des IGBTs aus dem nicht dargestellten Gehäuse des Submoduls geführt werden.
Die Verbindungsleitung 9 kann beispielsweise aus einer Metall-Bondverbindung oder aus Metallkabel, Metalldrahtgeflechten oder Metallfolien gefertigt sein. Besonders geeignetes Metall ist etwa Kupfer.
Fig. 2 zeigt eine erste bevorzugte Variante der ersten Ausführungsform des erfindungsgemässen Leistungshalbleiter-Submoduls. Dargestellt sind lediglich zwei in Serie geschaltete Dioden, aber natürlich können wie in der vorhergehenden Ausführungsform weitere Halbleiterchips parallel geschaltet sein. Anstelle der direkten Verbindungsleitung sind zwischen der ersten Hauptelektrode 4 der zweiten Diode 22 und der ersten Isolierschicht 10 sowie zwischen der zweiten Hauptelektrode 3 der ersten Diode 21 und der zweiten Isolierschicht 11 elektrisch leitfähige Verbindungsplatten 93 und 94 angeordnet. Diese sind im wesentlichen parlallel zueinander angeordnet und überlappen sich in einem Bereich zwischen den beiden Dioden. Um die beiden Verbindungsplatten elektrisch leitend zu verbinden, ist zwischen ihnen im Bereich der Überlappung eine Verbindungsschicht 95, vorzugsweise aus Kupfer oder einem anderen gut leitenden Material, angeordnet.
Um den Kontakt zwischen den Verbindungsplatten 93 und 94 und der Verbindungsschicht 95 zu verbessern, können diese entweder zusammengelötet werden, mittels Low-Temperature-Bonding (LTB) verbunden werden und/ oder wie in der Fig. 2 dargestellt mit einem Kontaktstempel 81 mit einer erhöhten Kontaktkraft beaufschlagt werden. Besonders vorteilhaft ist dabei, dass die Kontaktstempel 8 und 81 alle die gleiche Länge haben, was sich für die Herstellung und die Montage als günstig erweist.
Die Verbindungsleitung mit flachen, geraden Platten ist einfacher herzustellen und zu montieren und weist gegenüber einer gebogenen, nahezu S-förmigen Verbindungsleitung eine geringere Induktivität auf. Zudem ist die flache Verbindungsleitung einfacher elektrisch zu isolieren als eine gebogene.

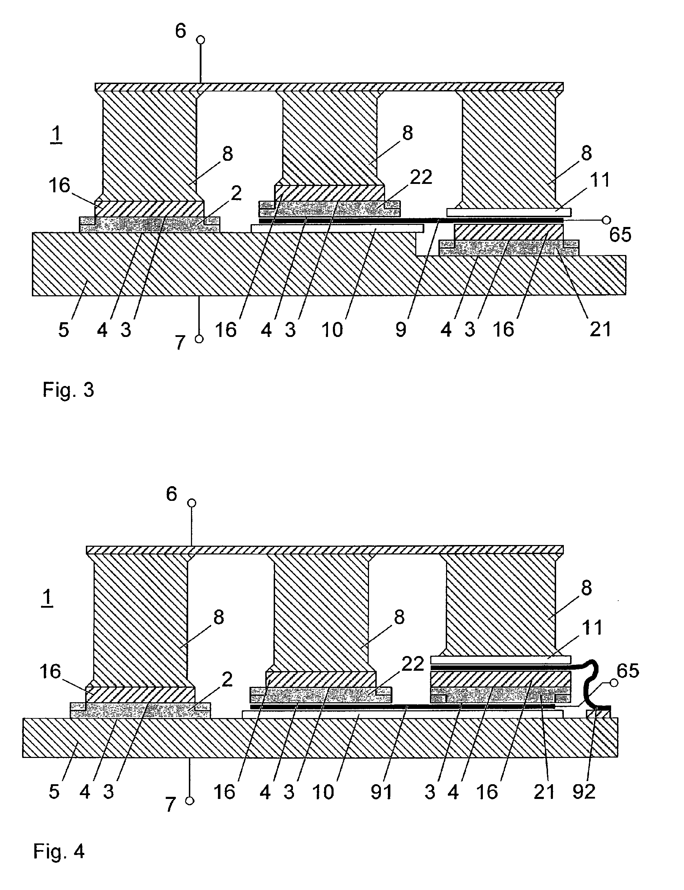

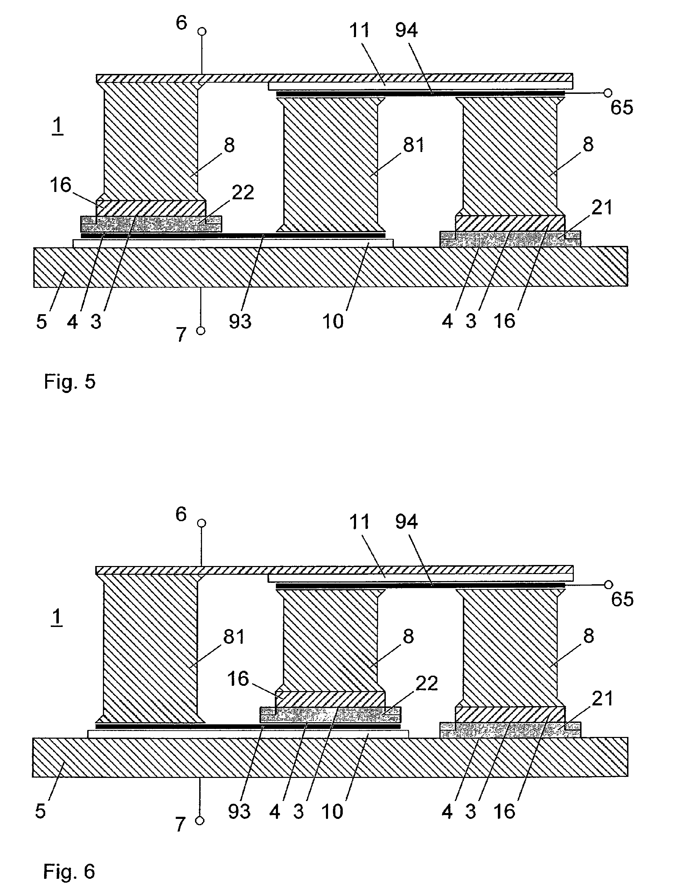

Fig. 3 zeigt eine zweite bevorzugte Variante der ersten Ausführungsform des erfindungsgemässen Leistungshalbleiter-Submoduls. Im Gegensatz zu der in den ersten beiden Figuren dargestellten Variante, ist die Grundplatte 5 mit einer Struktur versehen, so dass der eine Halbleiterchip, in diesem Fall die erste Diode 21 gegenüber den anderen Halbleiterchip auf einer anderen, tieferen Ebene aufliegt. Die Grundplatte ist mit einer Stufe versehen, so dass die auf der unteren Stufe angeordnete Diode mit der obenliegenden, zweiten Hauptelektrode 3, rsp. den darauf angeordneten Schichten 16 auf einer Ebene liegt mit der auf der ersten Isolierschicht 10 aufliegenden ersten Hauptelektrode 4 der zweiten Diode 22.
Dies ermöglicht die Serienschaltung der beiden Dioden mittels einer einzigen geraden Verbindungsleitung 9.
Fig. 4 zeigt eine zweite Ausführungsform des erfindungsgemässen Leistungshalbleiter-Submoduls. Wiederum ist einem IGBT 2 eine Serienschaltung von zwei Dioden parallelgeschaltet. Die zweite Diode 22 ist wiederum auf einer ersten Isolierschicht 10 angeordnet, welche nun jedoch verlängert ist, so dass auch die erste Diode 21 auf ihr aufliegt. Die erste Diode 21 ist jedoch gegenüber der zweiten Diode gewendet, das heisst auf den Kopf gestellt (flip-chip). Die beiden Dioden, genauer die zweite Hauptelektrode 3 der ersten Diode 21 und die erste Hauptelektrode 4 der zweiten Diode 22, sind mit einer auf der Isolierschicht 10 angeordneten ersten Verbindungsleitung 91 elektrisch leitend verbunden. Von der ersten Hauptelektrode 4 der ersten Diode 21, welche mit einer zweiten Isolierschicht 11 von dem darüberliegenden Kontaktstempel 8 elektrisch isoliert ist, ist eine zweite Verbindungsleitung 92 auf die Grundplatte geführt.
Natürlich kann diese zweite Verbindungsleitung auf eine weitere Diode oder ein anderer Halbleiterchip geführt, und ebenfalls mit den beiden Dioden in Serie geschaltete sein.
Eine dritte Ausführungsform des erfindungsgemässen Leistungshalbleiter-Submoduls ist in den Fig. 5 und 6 dargestellt. Dabei handelt es sich um eine einfache Serienschaltung von zwei Halbleiterchips 21 und 22. Natürlich können wiederum weitere Halbleiterchips parallel geschaltet sein.
Wie bereits die in Fig. 2 dargestellte Variante der ersten Ausführungsform des erfindungsgemässen Leistungshalbleiter-Submoduls, werden als Verbindungsleitung flache, ebene Verbindungsplatten 93 und 93 eingesetzt.

Bei der ersten, in Fig. 5 dargestellten Variante ist die erste Verbindungsplatte 93 zwischen der ersten Isolierschicht 10 und der ersten Hauptelektrode 4 der zweiten Diode 22 angeordnet und seitlich verlängert bis in den Bereich zwischen den beiden Dioden. Die zweite Verbindungsplatte 94 hingegen ist aus Sicht der ersten Diode 21 nach dem Kontaktstempel 8, im Bereich des zweiten Hauptanschlusses 6 angeordnet. Zwischen der zweiten Verbindungsplatte 94 und dem zweiten Hauptanschluss 6 ist die zweite elektrisch isolierende Schicht 11 angeordnet, so dass die zweite Verbindungsplatte 94 vom zweiten Hauptanschluss 6 elektrisch isoliert ist. Die zweite Verbindungsplatte 94 ist ebenfalls seitlich verlängert bis in den Bereich zwischen den beiden Dioden. Die beiden Verbindungsplatten 93 und 94 sind mittels einem Kontaktstempel 81 elektrisch leitend verbunden.
In der zweiten, in Fig. 6 dargestellten Variante sind die beiden Halbleiterchips von Fig. 5 antiseriell geschaltet, das heisst, die zweite Diode 22 ist in der Serienschaltung umgekehrt gepolt. Dies wird erreicht, indem die zweite Diode 22 ebenfalls mit der ersten Hauptelektrode 4 auf der ersten Verbindungsplatte 93 aufliegt, diese jedoch nicht in Richtung der ersten Diode seitlich verlängert ist, sondern in die andere Richtung, und über ein Kontaktstempel 81 direkt mit dem zweiten Hauptanschluss 6 elektrisch leitend verbunden ist. Die zweite Hauptelektrode 3 der zweiten Diode 22 ist über einen Kontaktstempel 8 mit der zweiten Verbindungsplatte 94 elektrisch leitend verbunden.
Diese Ausführungsform hat den Vorteil, dass die stromführenden Teile weitmöglichst auseinander liegen. Zudem lässt sich im Bereich der zweiten Verbindungsplatte 94, welche sich am oberen Rand des Submoduls befindet, eine einfache externe Kontaktierung zwischen den beiden Dioden realisieren.
Durch die Serienschaltung von mehreren Halbleiterchips in einem Submodul ist es möglich, in einem Submodul einfache Schaltungen zu realisieren, beispielsweise eine Parallelschaltung eines IGBTs mit zwei seriengeschalteten Dioden. Mit herkömmlichen Submodulen kann eine solche Schaltung nur mit doppelter Höhe realisiert werden.

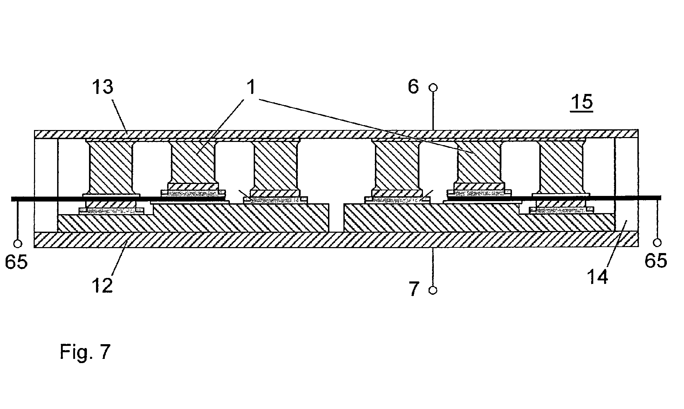

Fig. 7 zeigt ein erfindungsgemässes Leistungshalbleiter-Modul mit drei der oben beschriebenen Leistungshalbleiter-Submodulen. Zwischen einer elektrisch leitenden Deckelplatte 13 und einer elektrisch leitendenden Bodenplatte 12 sind die Leistungshalbleiter-Submodule 1 eingepresst. Die Deckel- und Bodenplatte werden von einem elektrisch isolierenden Gehäuse 14 getragen. Das Gehäuse trägt insbesondere zu grossen Anpressdruck, so dass die Halbleiter in den Submodulen nicht zu stark mit Druck beaufschlagt werden.
Über die Deckel- und Bodenplatte sind die Hauptanschlüsse 6 und 7 mit den Submodulen verbunden. Weitere Anschlüsse, beispielsweise Steueranschlüsse von IGBTs oder ein Mittelpunktanschluss 65 zweier in Serie geschalteter Dioden sind seitlich aus dem Gehäuse des Leistungshalbleiter-Moduls geführt.
Solche Module sind speziell für Anwendungen in einem Stack geeignet. Wie erwähnt, reduziert sich die Höhe des Stacks, dank der Serienschaltung von Halbleiterchips in den einzelnen Submoduls.
Im Sinne der Erfindung umfasst der allgemeine Begriff der Serienschaltung auch das Hintereinanderschalten zweier Komponenten mit entgegengesetzter Polarität (Anti-Serienschaltung).

### Bezugszeichenliste

- 1: Leistungshalbleiter-Submodul
- 2, 21, 22: Halbleiterchips
- 3, 4: Hauptelektroden
- 5: Grundplatte
- 6, 7: Hauptanschlüsse
- 8, 81: Kontaktstempel
- 9, 91,92, 93, 94, 95: Verbindungsleitungen, Verbindungsplatten
- 10, 11: Isolierschichten
- 12, 13: Boden-, Deckelplatte
- 14: Isoliergehäuse
- 15: Leistungshalbleiter-Modul
- 16: SCFM-Layer
- 65: Verbindungsleitungsanschluss

## Patentansprüche

1. Leistungshalbleiter-Submodul (1) mit
- mehreren Halbleiterchips (2, 21, 22), welche
- mindestens zwei Elektroden, nämlich eine erste (4) und eine zweite Hauptelektrode (3), aufweisen, welche
- mit einer durch einen Kontaktstempel (8) auf eine der beiden Hauptelektroden (3, 4) ausgeübten Kontaktkraft beaufschlagt mit der anderen Hauptelektrode (4, 3) auf einer Grundplatte (5) aufliegen, mit
- einem ersten Hauptanschluss (7), welcher
- mit der Grundplatte (5) elektrisch zusammenwirkt und
- mit einer ersten Hauptelektrode (4) mindestens eines ersten Halbleiterchips (21) in elektrischer Verbindung steht, und mit
- einem zweiten Hauptanschluss (6), welcher
- mit einer zweiten Hauptelektrode (3) mindestens eines zweiten, mit der ersten Hauptelektrode (4) auf der Grundplatte (5) aufliegenden Halbleiterchips (22) in elektrischer Verbindung steht, und
- mit dem entsprechenden Kontaktstempel (8) elektrisch zusammenwirkt,
**dadurch gekennzeichnet, dass**
- der erste Halbleiterchip (21) und der zweite Halbleiterchip (22) zwischen dem ersten Hauptanschluss (7) und dem zweiten Hauptanschluss (6) elektrisch in Serie geschaltet sind.

2. Leistungshalbleiter-Submodul nach Anspruch 1, **dadurch gekennzeichnet, dass**
- zwischen der ersten Hauptelektrode (4) des zweiten Halbleiterchips (22) und der Grundplatte (5) eine erste elektrisch isolierende Schicht (10) angeordnet ist, dass
- zwischen der zweiten Hauptelektrode (3) des ersten Halbleiterchips (21) und dem entsprechenden Kontaktstempel (8) eine zweite elektrisch isolierende Schicht (11) angeordnet ist, und dass
- die erste Hauptelektrode (4) des zweiten Halbleiterchips (22) und die zweite Hauptelektrode (3) des ersten Halbleiterchips (21) über eine Verbindungsleitung (9, 91, ..., 95) elektrisch leitend verbunden sind.

3. Leistungshalbleiter-Submodul nach Anspruch 2, **dadurch gekennzeichnet, dass**
- die erste Hauptelektrode (4) des zweiten Halbleiterchips (22) und die zweite Hauptelektrode (3) des ersten Halbleiterchips (21) im wesentlichen in einer zur Grundplatte (5) parallelen Ebene liegen, und dass
- die Verbindungsleitung (9) im wesentlichen flach ausgebildet ist und in dieser Ebene verläuft.

4. Leistungshalbleiter-Submodul nach einem der Ansprüche 2 oder 3, **dadurch gekennzeichnet, dass**
- die im wesentlichen flach ausgebildete Grundplatte (5) im Bereich der Halbleiterchips (21, 22) unterschiedliche Dicken aufweist, so dass
- die ersten Hauptelektroden (4) des ersten und zweiten Halbleiterchips in getrennten, zur Grundplatte (5) parallelen Ebenen liegen.

5. Leistungshalbleiter-Submodul nach Anspruch 1, **dadurch gekennzeichnet, dass**
- der erste Halbleiterchip (21) mit der zweiten Hauptelektrode (3) auf der Grundplatte aufliegt, dass
- auf der Grundplatte (5), zwischen der ersten Hauptelektrode (4) des zweiten Halbleiterchips (22) und der Grundplatte (5) sowie zwischen der zweiten Hauptelektrode (3) des ersten Halbleiterchips (21) und der Grundplatte (5), eine erste elektrisch isolierende Schicht (10) angeordnet ist, dass
- zwischen der ersten Hauptelektrode (4) des ersten Halbleiterchips (21) und dem entsprechenden Kontaktstempel (8) eine zweite elektrisch isolierende Schicht (11) angeordnet ist, dass
- die erste Hauptelektrode (4) des zweiten Halbleiterchips (22) und die zweite Hauptelektrode (3) des ersten Halbleiterchips (21) über eine erste Verbindungsleitung (91) elektrisch leitend verbunden sind, und dass
- die erste Hauptelektrode (4) des ersten Halbleiterchips (21) über eine zweite Verbindungsleitung (92) mit der Grundplatte (5) elektrisch leitend verbunden ist.

6. Leistungshalbleiter-Submodul nach einem der Ansprüche 2 bis 5, **dadurch gekennzeichnet, dass**
- die Verbindungsleitungen (9, 91, 92) Kupfer-Bondverbindungen (direct copper bond) und/ oder Metalkabel und/ oder Metalldrahtgeflechte und/ oder Metallfolien umfasst.

7. Leistungshalbleiter-Submodul nach Anspruch 2, **dadurch gekennzeichnet, dass**
- die Verbindungsleitung
- eine erste elektrisch leitende Verbindungsplatte (93), welche zwischen der ersten Hauptelektrode (4) des zweiten Halbleiterchips (22) und der ersten Isolierschicht (10) angeordnet ist,
- eine zweite elektrisch leitende Verbindungsplatte (94), welche zwischen der zweiten Hauptelektrode (3) des ersten Halbleiterchips (21) und der zweiten Isolierschicht (11) angeordnet ist, sowie
- eine die erste und die zweite Verbindungsplatte (93, 94) elektrisch leitend verbindende Verbindungsschicht (95), welche zwischen der ersten und der zweiten Platte (93, 94) angeordnet ist,
umfasst.

8. Leistungshalbleiter-Submodul nach Anspruch 7, **dadurch gekennzeichnet, dass**
- die zweite Verbindungsplatte (94), die Verbindungsschicht (95) sowie die erste Verbindungsplatte (94) durch ein Kontaktstempel (81) mit einer Kontaktkraft beaufschlagt sind.

9. Leistungshalbleiter-Submodul nach Anspruch 1, **dadurch gekennzeichnet, dass**
- zwischen der ersten Hauptelektrode (4) des zweiten Halbleiterchips (22) und der Grundplatte (5) eine erste elektrisch isolierende Schicht (10) angeordnet ist, dass
- zwischen dem zweiten Hauptanschluss (6) und dem die zweite Hauptelektrode (3) des ersten Halbleiterchips (21) kontaktierenden Kontaktstempel (8) eine zweite elektrisch isolierende Schicht (11) angeordnet ist, und dass
- die erste Hauptelektrode (4) oder die zweite Hauptelektrode (3) des zweiten Halbleiterchips (22) und der die zweite Hauptelektrode (3) des ersten Halbleiterchips (21) kontaktierende Kontaktstempel (8) über eine Verbindungsleitung (93, 94) elektrisch leitend verbunden sind.

10. Leistungshalbleiter-Submodul nach Anspruch 9, **dadurch gekennzeichnet, dass**
- die Verbindungsleitung
- eine erste elektrisch leitende Verbindungsplatte (93), welche zwischen der ersten Hauptelektrode (4) des zweiten Halbleiterchips (22) und der ersten Isolierschicht (10) angeordnet ist,
- eine zweite elektrisch leitende Verbindungsplatte (94), welche zwischen dem die zweite Hauptelektrode (3) des ersten Halbleiterchips (21) kontaktierende Kontaktstempel (8) und der zweiten Isolierschicht (11) angeordnet ist, sowie
- einen die erste und die zweite Verbindungsplatte (93, 94) elektrisch leitend verbindenden Kontatkstempel (81)
umfasst.

11. Leistungshalbleiter-Submodul nach Anspruch 9, **dadurch gekennzeichnet, dass**
- ein Kontaktstempel (81) eine erste elektrisch leitende Verbindungsplatte (93), welche zwischen der ersten Hauptelektrode (4) des zweiten Halbleiterchips (22) und der ersten Isolierschicht (10) angeordnet ist, mit dem zweiten Hauptanschluss (6) elektrisch leitend verbindet, und dass
- die Verbindungsleitung
- eine zweite elektrisch leitende Verbindungsplatte (94), welche zwischen dem die zweite Hauptelektrode (3) des ersten Halbleiterchips (21) kontaktierende Kontaktstempel (8) und der zweiten Isolierschicht (11) angeordnet ist, sowie
- einen die zweite Hauptelektrode (3) des zweiten Halbleiterchips (22) und die zweite Verbindungsplatte (94) elektrisch leitend verbindenden Kontatkstempel (8)
umfasst.

12. Leistungshalbleiter-Modul (15) mit
- einer elektrisch leitfähigen Bodenplatte (12) und einer elektrisch leitfähigen Deckelplatte (13), mit
- einem zwischen Boden- und Deckelplatte angeordneten druckfesten Isoliergehäuse (14), und mit
- einem oder mehreren nebeneinander angeordneten und/ oder parallel geschalteten Leistungshalbleitersubmodulen nach einem der Ansprüche 1 bis 11, wobei
- die Bodenplatte (12) mit dem ersten Hauptanschluss (6) elektrisch leitend verbunden ist, und
- die Deckelplatte (13) mit dem zweiten Hauptanschluss (7) elektrisch leitend verbunden ist.
